(19) **Europäisches Patentamt / European Patent Office / Office européen des brevets**

(11) **EP 1 425 849 B1**

(12) **EUROPEAN PATENT SPECIFICATION**

(45) Date of publication and mention
of the grant of the patent:
**01.06.2011 Bulletin 2011/22**

(21) Application number: **02759023.1**

(22) Date of filing: **09.08.2002**

(51) Int Cl.:
**H03F 1/32** $^{(2006.01)}$

(86) International application number:
**PCT/SE2002/001440**

(87) International publication number:
**WO 2003/019773 (06.03.2003 Gazette 2003/10)**

(54) **CALIBRATION OF AN ADAPTIVE SIGNAL CONDITIONING SYSTEM**

KALIBRATION EINES ADAPTIVEN SIGNALKONDITIONIERUNGSSYSTEMS

ETALONNAGE D'UN SYSTEME ADAPTATIF DE CONDITIONNEMENT DE SIGNAUX

(84) Designated Contracting States:
**AT BE BG CH CY CZ DE DK EE ES FI FR GB GR IE IT LI LU MC NL PT SE SK TR**

(30) Priority: **28.08.2001 SE 0102885**

(43) Date of publication of application:
**09.06.2004 Bulletin 2004/24**

(73) Proprietor: **Telefonaktiebolaget LM Ericsson (publ)**
**164 83 Stockholm (SE)**

(72) Inventors:
• **LEYONHJELM, Scott**
  **S-172 34 Sundbyberg (SE)**
• **BJÖRK, Vimar**
  **S-416 56 Göketor (SE)**

• **LEATHER, Paul**
  **F-66740 Laroque-des-Albères (FR)**
• **NEOVIUS, Lennar**
  **S-18132 Lidingö (SE)**
• **GASS, John**
  **Swindon SN6 8AS (GB)**

(74) Representative: **Kühn, Friedrich Heinrich et al**
**Ericsson AB**
**Patent Unit LTE**
**Torshamnsgatan 23**
**164 80 Stockholm (SE)**

(56) References cited:
**EP-A2- 0 598 585     WO-A1-01/08294**
**US-A- 5 396 189     US-A- 5 574 992**
**US-A- 5 770 971     US-A- 5 937 011**
**US-A1- 2001 010 500**

**Description**

**TECHNICAL FIELD OF THE INVENTION**

The present invention generally relates to an adaptive signal conditioning system and a method for calibration of such a system, as well as the implementation of adaptive signal conditioning techniques in a power amplifier system and a multi-branch transmitter system.

**BACKGROUND OF THE INVENTION**

Adaptive signal conditioning systems can be found in all areas of electronics and communication, and are generally used for adaptively conditioning the input signal to a signal conversion system such as an amplifier chain or any other suitable system in order to continuously provide a desired output signal of the overall system.

Predistortion is a signal conditioning technique, which is used in connection with for example power amplifier and transmitter systems, as described in references [1-9] . The main objective of predistortion is to compensate for distortion caused by the power amplifier or similar system by predistorting the input signal to the power amplifier with the "inverse" of the distortion characteristics of the power amplifier. Ideally, the cascaded response of the inverse predistortion function and the transfer function of the power amplifier results in an overall linear gain and phase transfer function. Typically, the inverse or complementary predistortion function is based on the approximation of the amplifier being modeled by a power series and characterized by its AM-AM (AM, Amplitude Modulation) and AM-PM (PM, Phase Modulation) characteristics. The inverse predistortion function may also include higher-order effects such as thermal properties of the power transistor and/or frequency-dependent properties due to the bias and matching circuitry. However, since the distortion caused by the power amplifier may change over time due to factors such as variations in ambient temperature and component aging, an adaptive predistortion scheme is employed to maintain the linearity. In general, an adaptive predistortion scheme requires a feedback from the output of the power amplifier and an associated adaptation control unit to keep track of changes in the transfer characteristics of the power amplifier and to adapt the predistortion function in response thereto.

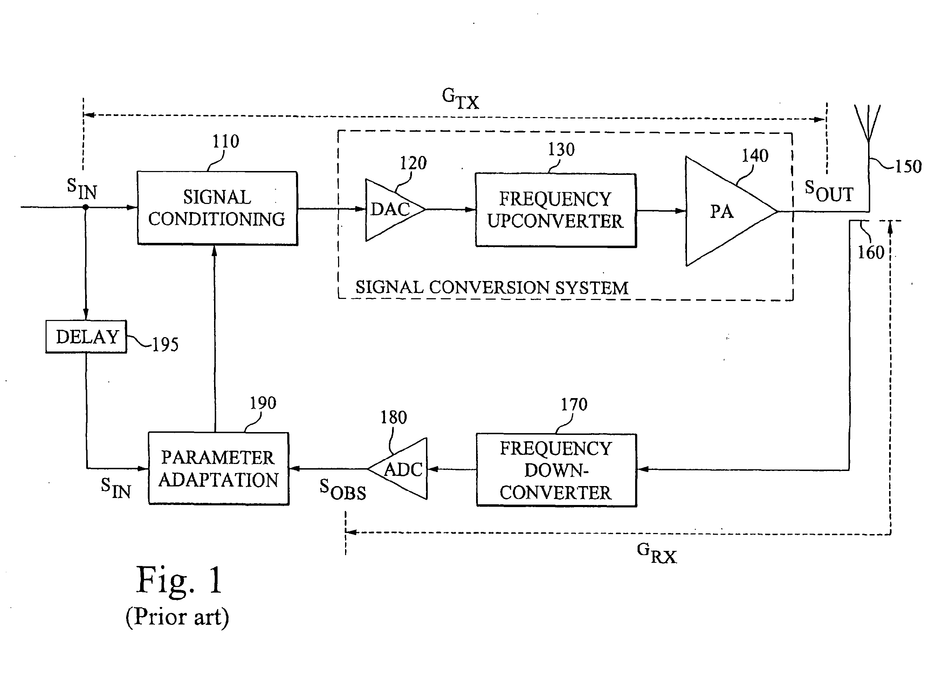

Fig. 1 is a schematic block diagram illustrating a typical adaptive digital predistortion system applied in connection with a power amplifier. The input signal $S_{IN}$ is provided to a signal-conditioning block 110. The input signal is here assumed to be a digital signal, which has been subjected to conventional baseband processing. The signal conditioning block 110 implements a predistortion function and modifies the baseband data signal according to the predistortion function. The resulting predistorted signal is then converted into the analog domain in a digital-to-analog converter (DAC) 120 and up-converted to the radio frequency band in a frequency up-converter 130. Finally, the up-converted signal is amplified by the power amplifier (PA) 140 into an output signal $S_{OUT}$, which is transmitted through an antenna 150.

The series connection of the digital-to-analog converter 120, the frequency up-converter 130 and the power amplifier 140 in the signal path after the signal conditioning block 110 is generally regarded as a signal conversion system. The predistortion function implemented in the signal conditioning block 110 generally represents the inverse of the distortion characteristics of the complete signal conversion system or appropriate parts thereof. In most cases, the power amplifier 150 stands for the dominant part of the distortion characteristics, and therefore the predistortion function is often provided as the inverse of the power amplifier distortion characteristics.

In order to enable adaptation of the predistortion function, a feedback path is arranged for providing an observed signal $S_{OBS}$ in response to the output signal $S_{OUT}$ of the power amplifier. The feedback path comprises a probe 160 for probing the power amplifier output, a frequency down-converter 170 and an analog-to-digital-converter (ADC) 180. The observed feedback signal $S_{OBS}$ is provided to a parameter adaptation unit 190, which adapts the parameters of the predistortion function based on the observed signal $S_{OBS}$ and a delayed version, using delay block 195, of the input signal $S_{IN}$.

As long as the observed signal $S_{OBS}$ is an accurate representation of the output signal $S_{OUT}$, the parameter adaptation will maintain an accurate and linear response of the forward transmission path. In practice, however, the transfer characteristics of the feedback path changes dynamically due to variations in temperature and frequency such that the observed signal $S_{OBS}$ at the output of the feedback path no longer is an accurate representation of the output signal $S_{OUT}$. This may severely affect the overall performance of the adaptive predistortion technique. In fact, dynamic changes in the transfer characteristics of the feedback path is a key problem affecting the very core of any adaptive signal conditioning system.

For example, this problem manifests itself with respect to the need to maintain a specified signal level at the output of the power amplifier or similar signal conversion system. With reference once again to Fig. 1, it can be appreciated that the output signal $S_{OUT}$ is related to the input signal $S_{IN}$ and the transmission gain $G_{TX}$ in the following way:

$$S_{OUT} = S_{IN} \cdot G_{TX} \tag{1}$$

Accordingly, it can be seen that the requirement of maintaining a specified output level can alternatively be expressed as maintaining a constant transmission gain $G_{TX}$.

As pointed out above, the adaptive predistortion technique relies on the feedback path for providing an observed signal $S_{OBS}$ in response to the output signal $S_{OUT}$, as well as the parameter adaptation in which the observed signal $S_{OBS}$ is compared to the delayed version of the input signal $S_{IN}$ with the goal of making $S_{OBS}$ equal to $S_{IN}$. In practice, the feedback path has a gain $G_{RX}$, and the relation between the observed signal $S_{OBS}$ and the output signal $S_{OUT}$ can be expressed as:

$$S_{OBS} = S_{OUT} \cdot G_{RX} \tag{2}$$

By combining expressions (1) and (2), the following relation between the observed signal $S_{OBS}$ and the input signal $S_{IN}$ is obtained:

$$S_{OBS} = G_{RX} \cdot G_{TX} \cdot S_{IN} \tag{3}$$

Since the goal of the parameter adaptation is to make $S_{OBS}$ equal to $S_{IN}$, the parameter adaptation with respect to gain is working properly as long as the following holds true:

$$G_{RX} \cdot G_{TX} = 1 \tag{4}$$

The output signal $S_{OUT}$ is maintained at a specified level as long as both $G_{RX}$ and $G_{TX}$ do not change. However, in practice, both $G_{RX}$ and $G_{TX}$ change due to factors such as temperature variations and component aging. The gain factors $G_{RX}$ and $G_{TX}$ could possibly change in such a way that $G_{RX} \cdot G_{TX} = 1$. While this would not influence the predistortion parameter adaptation, it would result in an incorrect output signal since the altered transmission gain $G_{TX} = (G_{TXinitial} + G_{TXchange})$ will be incorrect. Naturally, the gain factors $G_{RX}$ and $G_{TX}$ may change in such a way that $G_{RX} \cdot G_{TX}$ does not equal 1. This also results in an incorrect output signal $S_{OUT}$.

In most applications, the system requirements on output power accuracy make it necessary to control the output signal level. Radio transmitters for example typically have requirements that the output signal level should be accurate within the range of +/- 0.5 to +/- 3.0 dB. The accuracy is especially important in CDMA systems where the output power of a base station or a terminal has to be controlled very accurately in order not to sacrifice system capacity. Due to radio transmitters being subject to high variations in ambient temperature and then including other effects such as aging, transmission frequency changes and power supply variations, there is a need to correct the gain variations of $G_{RX}$ and $G_{TX}$.

With adaptive predistortion, the problem is generally simplified to keeping either $G_{RX}$ or $G_{TX}$ constant as the parameter adaptation is capable of keeping the other gain factor constant. However, if both $G_{RX}$ and $G_{TX}$ change, additional information and a corresponding adaptation process are required to correct for the second gain variation.

In this respect, a straightforward technique is to fully characterize either the transmission path or the feedback path over known variables such as temperature and transmission frequency at manufacture and then compensate for the gain variations by means of a gain-compensating device. It is known to use look-up tables that are addressed during operation to provide the required correction coefficients to the gain-compensating device. Another option is simply to select a suitable passive attenuator to compensate for the gain variations.

Pre-characterization however has the disadvantage that there is some uncertainty whether the gain compensation will remain accurate with the aging of the many components involved. Another disadvantage is the time required during production to complete the characterization and/or to calculate the compensation coefficients.

A more advanced technique, used in the commercially available radio base station RBS 1107/1127 from Ericsson, involves a transmission power tracking loop that maintains the gain of the transmission path based on actual measurements of the output power of the power amplifier and the input power to the adaptive predistortion system using dedicated power detectors. In this way, since the transmission path is gain calibrated, the parameter adaptation is capable of keeping the gain of the feedback path constant. However, the power detectors must still be calibrated over all known relevant variables such as power, temperature and frequency. Although the power detector components are relatively few compared to the complete transmission path, this represents the same disadvantage as mentioned earlier, including uncertainty with aging and the time required in production.

## SUMMARY OF THE INVENTION

The present invention overcomes these and other drawbacks of the prior art arrangements.

It is a general object of the present invention to provide an improved adaptive signal conditioning system.

It is another object of the invention to provide a mechanism for robust and efficient calibration of an adaptive signal conditioning system.

Yet another object of the invention is to provide a power amplifier system as well as a multi-branch transmitter system such as an adaptive antenna system or a transmit diversity system in which a robustly calibrated adaptive signal conditioning system is implemented.

These and other objects are met by the invention as defined by the accompanying patent claims.

The general idea according to the invention is to provide robust and efficient calibration of an adaptive signal conditioning system by selectively inserting a well-defined reference signal into the feedback path, and calibrating the feedback path based on the reference signal. The use of a reference signal for calibration of the feedback path means that the effects of changes in the transfer characteristics of the feedback path due to factors such as variations in ambient temperature and component aging are effectively removed. In this way, the feedback signal transferred over the calibrated feedback path will be an accurate representation of the output signal of the forward path, thus allowing accurate adaptive signal conditioning.

The feedback path may be calibrated with respect to any signal-affecting property such as the gain, phase shift or delay of the feedback path based on measurements of changes in the corresponding signal characteristics of the reference signal over the feedback path.

By using a predefined and stable reference signal, the nominal signal characteristics of the inserted reference signal is generally known. Accordingly, any changes in the transfer characteristics of the feedback path may typically be revealed by a simple comparison of the reference signal characteristics measured at the output of the feedback path and the known signal characteristics.

A correction coefficient set is determined based on the measured signal characteristics and the nominal signal characteristics of the inserted reference signal, and the feedback path is then calibrated based on the correction coefficient set.

Further, a reference signal compensator is generally employed for adjusting the reference signal according to commands from a signal adjustment controller to maintain the nominal signal characteristics of the reference signal.

In order to ensure that the predefined nominal signal characteristics of the reference signal is maintained over time, direct measurements or pre-characterization of the reference signal characteristics over variables such as temperature and frequency is utilized in preferred embodiments of the invention.

The invention is generally applicable and may be implemented with any system that requires accurate adaptive signal conditioning. For example, the invention may be implemented with a power amplifier system for maintaining an absolutely accurate and linear output response. In this regard, it may be of particular interest to maintain the output power accuracy of the power amplifier system by calibrating the feedback path of the adaptive signal conditioning system with respect to gain. Another important example involves a multi-branch transmitter system, such as an adaptive antenna system or a transmit diversity system, in which the invention is implemented for accurately controlling the gain, phase and/or delay. In an adaptive antenna system, the calibration according to the invention can be used for providing accurate gain and phase control. In a transmit diversity system, the invention can be used for accurate delay matching between different transmission branches.

The invention offers the following advantages:

- Robust and efficient calibration;
- Non-invasive calibration, since the calibration does not interrupt the normal operation of the forward path of the overall system;
- Automatic calibration during operation;
- Reduced need for costly calibration procedures during production;
- Absolute power accuracy in a power amplifier system;
- Accurate gain and phase control in an adaptive antenna system; and
- Accurate delay matching in a transmit diversity system.

Other advantages offered by the present invention will be appreciated upon reading of the below description of the embodiments of the invention.

## BRIEF DESCRIPTION OF THE DRAWINGS

The invention, together with further objects and advantages thereof, will be best understood by reference to the following description taken together with the accompanying drawings, in which:

Fig. 1 is a schematic block diagram illustrating a typical adaptive predistortion system applied in connection with a power amplifier;

Fig. 2 is a schematic block diagram illustrating a general adaptive signal conditioning system according to the invention, applied in connection with an arbitrary signal conversion system;

Fig. 3 is a schematic block diagram illustrating an adaptive signal conditioning system with switch-based insertion of the reference signal;

Fig. 4 is a schematic flow diagram of a method for calibrating an adaptive signal conditioning system according to a preferred embodiment of the invention, including calibrated operation of the signal conditioning system;

Fig. 5 is a schematic diagram of a reference signal generator block that is used by the invention for accurately maintaining the nominal reference signal characteristics;

Fig. 6 is a schematic block diagram illustrating an adaptive power amplifier system according to a preferred embodiment of the invention;

Fig. 7 illustrates an example of a coefficient calibrator for gain calibration of the feedback path of an adaptive signal conditioning system;

Fig. 8 is a schematic block diagram illustrating an adaptive antenna system according to a preferred embodiment of the invention;

Fig. 9 is a schematic block diagram illustrating an adaptive antenna system according to an alternative embodiment of the invention;

Fig. 10 is a schematic block diagram illustrating a transmit diversity system according to a preferred embodiment of the invention; and

Fig. 11 illustrates yet another multi-branch transmitter system of the invention.

## DETAILED DESCRIPTION OF EMBODIMENTS OF THE INVENTION

### *Calibration of a general adaptive signal conditioning system*

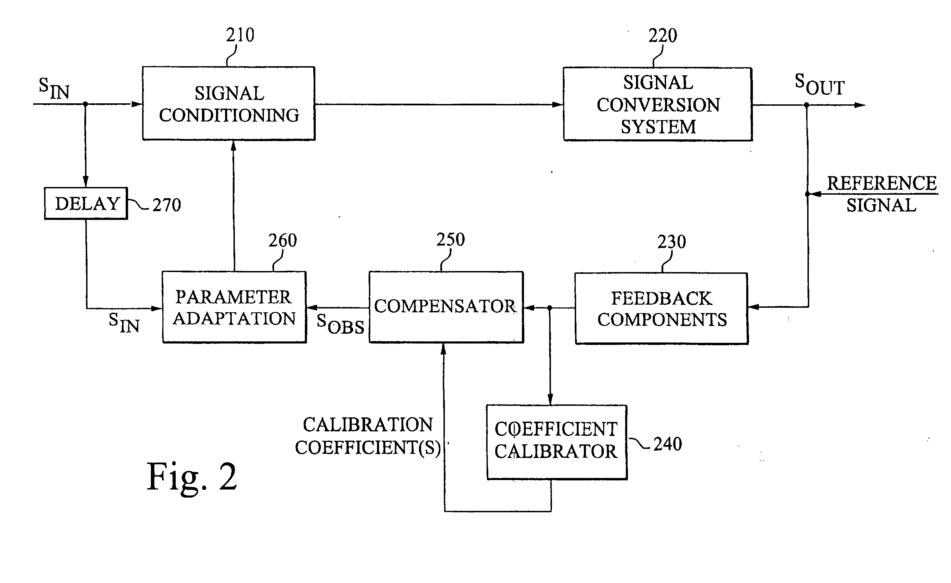

Fig. 2 is a schematic block diagram illustrating a general adaptive signal conditioning system according to the invention, applied in connection with an arbitrary signal conversion system. A signal conditioning block 210 is provided in the input signal path to a signal conversion system 220 for preconditioning the signal to be converted by the signal conversion system 220. In other words, the signal conditioning block 210 receives an input signal $S_{IN}$ and modifies the input signal according to the particular application. The resulting modified signal is then transferred to the signal conversion system 220, which converts the modified input signal into an output signal $S_{OUT}$. The signal conversion system 220 may be any signal conversion system known to the art, performing signal conversion such as amplification, attenuation, frequency conversion, phase shifting or any other filtering that affects the signal characteristics of the preconditioned input signal.

In order to enable adaptation of the signal conditioning performed by the signal conditioning block 210, a feedback path is arranged for providing an observed signal $S_{OBS}$ in response to the output signal $S_{OUT}$ of the signal conversion system 220. Typically, the feedback path comprises one or more operatively active feedback components 230 for normalizing the feedback signal to the same general format (analog/digital, the same frequency domain, etc.) as the input signal $S_{IN}$ to provide an appropriate representation of the output signal $S_{OUT}$ that can be compared to the input signal $S_{IN}$ during adaptation of the parameters used in the signal conditioning. However, the signal transfer characteristics of the feedback components 230 generally change dynamically due to for example component aging and variations in temperature and frequency, thus negatively affecting the very core of the adaptive signal conditioning technique.

In accordance with the invention, the detrimental effects of these dynamic changes in transfer characteristics are effectively eliminated by selectively inserting a reference signal into the feedback path and calibrating the feedback path based on the reference signal. It has been recognized that changes in the transfer characteristics of the feedback path can be determined by detecting changes in the signal characteristics of the reference signal over the feedback path. For this purpose, a coefficient calibrator 240 is preferably arranged to receive the reference signal as the reference signal has been transferred through the feedback components 230 and determine the changes in signal characteristics of the reference signal from the insertion point. In a straight forward application, this may be accomplished by a simple comparison of the signal characteristics measured by the coefficient calibrator 240 and the known nominal signal characteristics of the inserted reference signal. The calibrator 240 then calculates one or more calibration coefficients based on the determined changes in reference signal characteristics. The calculated calibration coefficient or coefficients are sent to a feedback compensator 250 that effectively compensates for, in the feedback signal, the changes in transfer characteristics of the feedback components.

Finally, the compensated observed signal $S_{OBS}$ is provided to a parameter adaptation block 260 together with a delayed version of the input signal $S_{IN}$. The input signal $S_{IN}$ is delayed using delay block 270 to compensate for the delay introduced by the feedback path. The parameter adaptation block 260 then adapts the parameters used by the signal conditioning block 210 based on the observed signal $S_{OBS}$ and the delayed input signal $S_{IN}$.

By virtue of the calibration procedure according to the invention, the observed signal $S_{OBS}$ will be a much more accurate representation of the output signal of the signal conversion system since the feedback path has been stabilized by the calibration. In order to maintain a stabilized feedback path, the calibration procedure is preferably repeated at selected times, or when needed as indicated by environmental or operational parameters. A calibrated feedback path that provides an accurate output signal representation is particularly important for adaptive signal conditioning in high-performance applications.

It should be understood that the feedback path may be calibrated with respect to any signal-affecting property such as the gain, phase shift or delay of the feedback path based on measurements of changes in the corresponding signal characteristics of the reference signal over the feedback path. This naturally means that the implementation of the coefficient calibrator 240 and the compensator 250 has to be adapted to the particular application. For example, the calibrator 240 may be provided with a signal level detector for gain calibration, a phase detector for phase calibration or a delay detector for delay calibration. The compensator 250 could be a simple multiplier for gain correction, a phase adjuster for phase correction, a complex multiplier for phase and gain correction, a delay filter (also referred to as a time shift filter) for delay correction, or even a complex filter for handling phase and gain variations that are frequency-dependent.

The reference signal could be a simple sinewave signal, a more complex signal such as a CDMA or multitone signal, or any other signal whose properties allow the characteristics of at least one of gain, phase and delay to be determined. The reference signal does not necessarily have to be a continuous signal, but could be provided in the form of a pulsed signal. The use of a pulsed reference signal has turned out to be particularly useful for delay calibration. In addition, the reference signal is preferably customized for the particular application in question, and may be adapted to operational parameters such as transmission frequency or adapted to the characteristics of the feedback component or components used in the feedback path.

If the reference signal is inserted directly onto the normal operational feedback signal to form a composite (feedback and reference) signal, the calibrator 240 is adapted to extract the reference signal part of the composite signal for use in the calibration. Normally, this also means that compensator 250 cancels the reference signal part of the composite signal to provide an accurate observed signal to the parameter adaptation block 260. In other words, the compensator 250 not only compensates for changes in feedback transfer characteristics but also cancels the reference signal from the composite (feedback and reference) signal.

Although the coefficient calibrator 240 and the compensator 250 are normally regarded as part of the calibrated feedback path, it should be understood that the calibrator 240 as well as the compensator 250 may be embedded, logically and/or physically, in the parameter adaptation block 260.

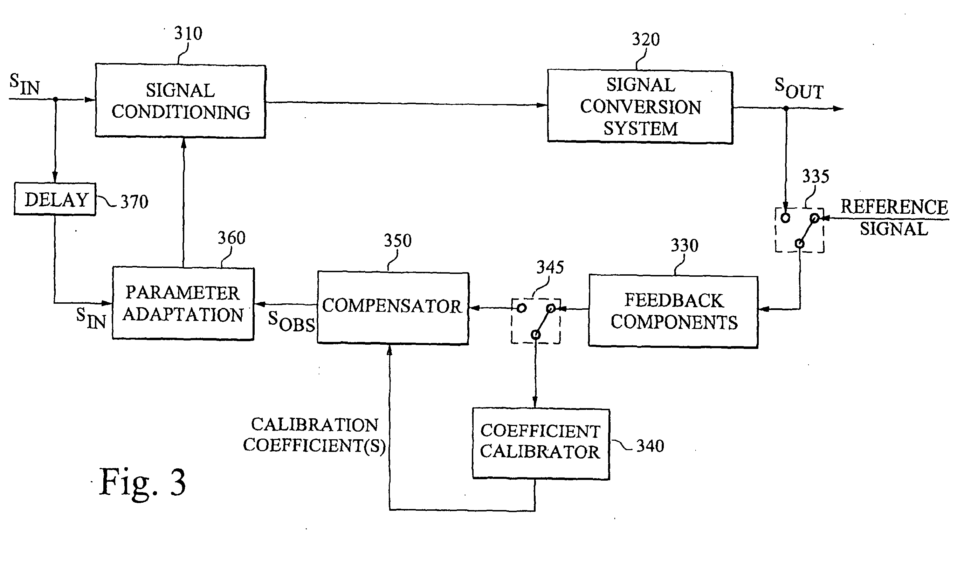

Alternatively, however, switches are used for selectively switching the reference signal into the feedback path instead of the output signal of the signal conversion system, and for selectively switching the reference signal to the calibrator as will be described below with reference to the block diagram of Fig. 3.

Fig. 3 is a schematic block diagram illustrating an adaptive signal conditioning system with switch-based insertion of the reference signal. The block diagram of Fig. 3 is similar to that of Fig. 2, except for two switches 335 and 345 in the feedback path. The first switch 335 receives the output signal of the signal conversion system 320 as well as the reference signal for selectively forwarding either the output signal of the signal conversion system or the reference signal in the feedback path. The second switch 345 receives the output signal of the feedback components 330 for selectively forwarding that signal either to the coefficient calibrator 340 or the compensator 350.

During calibration, the reference signal is switched into the feedback path by the first switch 335, and switched to the calibrator by the second switch 345. In this way, the reference signal is allowed to pass through the feedback components 330 and to the calibrator 340 so that the changes in reference signal characteristics from the insertion point can be determined. The calibrator 340 then determines an appropriate calibration coefficient based on the determined changes in reference signal characteristics.

In normal operation, the first switch 335 is operated so that the output signal of the signal conversion system is transferred over the feedback path. Now, the second switch 345 is operated to forward the feedback signal from the feedback components directly to the compensator 350, which then effectuates the calibration.

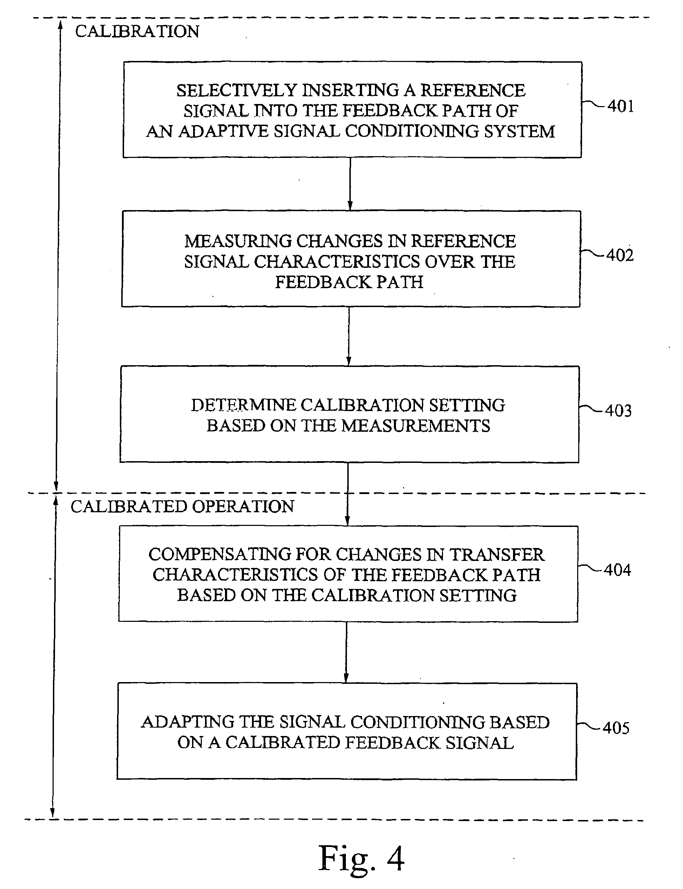

Fig. 4 is a schematic flow diagram of a method for calibrating an adaptive signal conditioning system according to a preferred embodiment of the invention, including calibrated operation of the signal conditioning system. The method illustrated in Fig. 4 includes a first calibration phase and a second operational phase. The calibration phase is initiated at selected times defined in the overall system, e.g. at regular intervals, by inserting a well-defined reference signal into the feedback path of the adaptive signal conditioning system (step 401). Next, changes in the transfer characteristics of the feedback path are estimated by measuring changes in the signal characteristics of the reference signal over the relevant sections of the feedback path (step 402). Based on these measurements, a calibration setting is determined (step 403) for enabling compensation for changes in the transfer characteristics of the feedback path. In the subsequent phase of calibrated operation, the calibration setting just determined will be used for compensating, in the feedback signal, for changes in feedback transfer characteristics (step 404) until a new, updated calibration setting is determined. Using the calibrated feedback signal in the parameter adaptation of the signal conditioning system, ensures proper and accurate signal conditioning (step 405).

### Maintaining the nominal signal characteristics of the reference signal

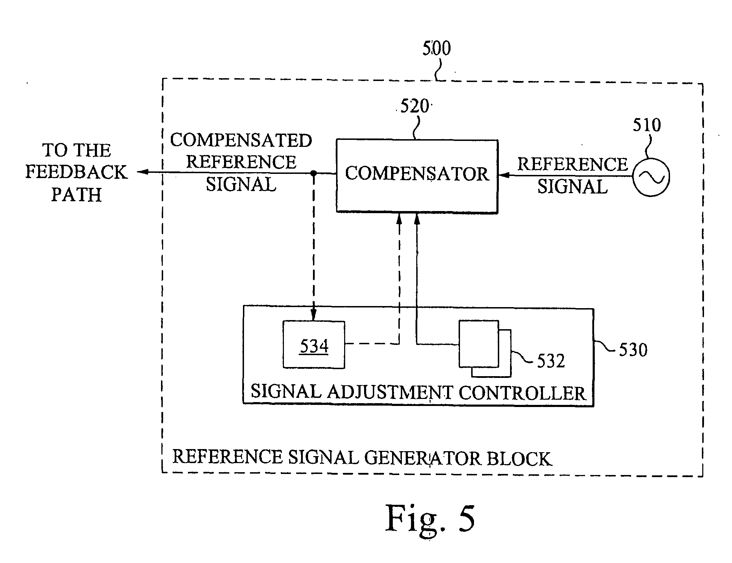

The calibration procedure according to the invention works perfectly well as long as the nominal signal characteristics of the inserted reference signal is maintained over time. If the reference signal itself is not maintained, the accuracy of the overall feedback calibration will drift due to various factors that affect the reference signal generator. In many applications, this is not critical, but in some applications, it may be necessary to calibrate the reference signal. An example of reference signal calibration that is used with the invention will now be described with reference to Fig. 5.

Fig. 5 is a schematic diagram of a reference signal generator block that is used by all embodiments of the invention for accurately maintaining the nominal reference signal characteristics, for example with respect to signal level, phase and/or delay. The reference signal generator block 500 basically comprises a signal generator 510 such as stable sinewave generator, a compensator 520 and a signal adjustment controller 530. The compensator 520 adjusts the reference signal from the signal generator 510 according to commands from the signal adjustment controller 530 to maintain the nominal signal characteristics of the reference signal. Preferably, the signal adjustment of the compensator 520 is performed based on pre-characterization of the reference signal characteristics with respect variables such as temperature, frequency and time. This can be accomplished by characterizing the variation in reference signal characteristics as being dependent on different variables. In a typical implementation, the signal adjustment controller 530 utilizes look-up tables 532 in which pre-characterized correction coefficients are stored. The look-up tables are addressed during operation such that they supply the required correction coefficients to the compensator 520 to maintain the nominal signal characteristics over time. The compensated reference signal is provided to the feedback path of an adaptive signal conditioning system to enable calibration.

Alternatively, the signal adjustment is performed based on direct measurements of the reference signal characteristics. For example, this may be accomplished by measuring the signal characteristics at the output of the compensator 520 and adjusting the operation of the compensator 520 by means of a calibrator 534.

As mentioned above, the invention is generally applicable and can be used for calibration of adaptive signal conditioning systems in different applications for various purposes. For example, the invention may be utilized for maintaining accurate and linear output response of a power amplifier system, for accurately controlling the gain and phase in an adaptive antenna system or for maintaining the desired accuracy of the delay matching between different transmission branches in a transmit diversity system, all as will be described in more detail below.

### Implementation in a power amplifier system

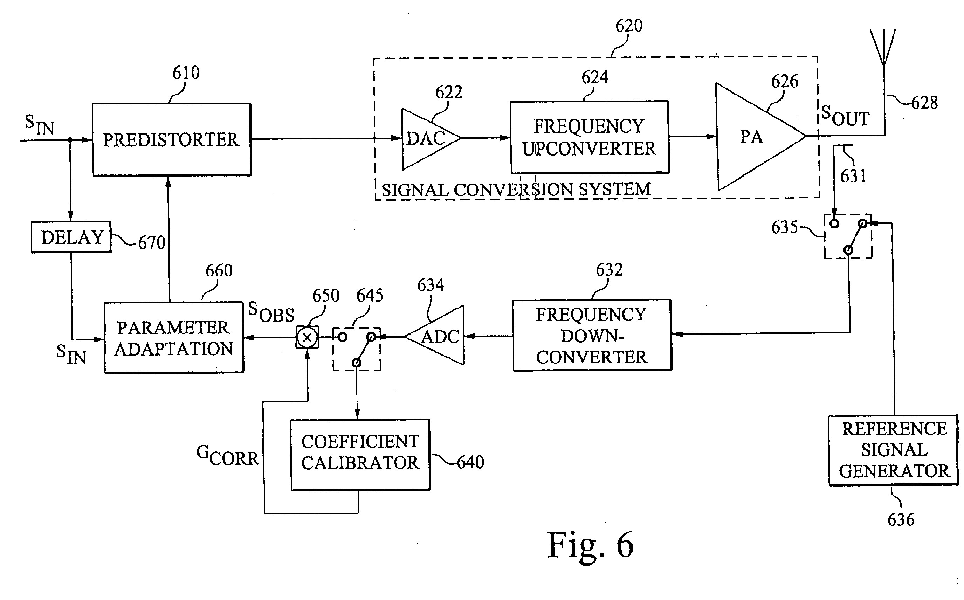

Fig. 6 is a schematic block diagram illustrating an adaptive power amplifier system according to a preferred embodiment of the invention. A digital predistorter 610 is arranged in the input signal path to an antenna-feeding signal conversion system 620 for predistorting the input signal $S_{IN}$ in order to compensate for the distortion characteristics of the overall signal conversion system 620 or appropriate parts thereof. In this example, the signal conversion system 620 includes a digital-to-analog converter (DAC) 622, a frequency up-converter 624 and a power amplifier (PA) 626.

The predistortion function implemented in the predistorter 610 typically represents either the inverse (also known as the complementary) of the distortion characteristics of the entire series connection of the DAC 622, the frequency up-converter 624 and the power amplifier 626 or the inverse of the power amplifier distortion characteristics. Preferably, the predistorter is based on conventional Cartesian or polar complex gain predistortion and the predistortion function is implemented by means of a look-up table containing complex gain correction factors. The look-up table is generally addressed based on the signal characteristics, typically the signal amplitude or power level, of the input signal $S_{IN}$. The address generated for a particular sample of the digital input signal $S_{IN}$ is used to select a complementary complex gain from the look-up table, and the selected complex gain is then processed together with the original input sample in a complex multiplier to generate the predistorted signal. Additional general information on the conventional aspects of digital predistortion can be found in the literature, for example in references [10-14].

The resulting predistorted signal is then converted into the analog domain in the DAC 622, and up-converted to the radio frequency band in the frequency up-converter 624. Finally, the up-converted radio signal is amplified by the power amplifier 626 into an output signal $S_{OUT}$, which is transmitted through the antenna 628.

The output signal $S_{OUT}$ of the power amplifier 626 is probed by a high-impedance probe or an RF-coupler 631 and transferred over a feedback path to provide a representation $S_{OBS}$ of the power amplifier output signal that can be compared to the input signal $S_{IN}$ during parameter adaptation. A switch 635 is incorporated in the feedback path for selectively forwarding either the probed output signal of the power amplifier 626 (normal operation) or a predefined reference signal from a reference signal generator 636 (calibration) to a frequency down-converter 632 and a subsequent analog-to-digital converter (ADC) 634. The output of the ADC 634 is connected to a further switch 645, which selectively forwards the digital output signal of the ADC 634 either to a coefficient calibrator 640 or a complex multiplier 650. The complex multiplier 650 is finally connected to a parameter adaptation block 660.

In order to make sure that the observed signal $S_{OBS}$ is an accurate representation of the power amplifier output signal $S_{OUT}$, the feedback path is preferably calibrated at regular intervals defined by the system. During calibration, the reference signal is switched into the feedback path by the switch 635, and transferred through the down-converter 632 and the ADC 634 onto the switch 645, which switches the reference signal to the coefficient calibrator 640. In this way, the reference signal is allowed to pass through the frequency down-converter 632 and ADC 634 to the calibrator 640. This means that changes in signal level and phase of the reference signal from the insertion point at the switch 635 to the calibrator 640 can be determined by the calibrator 640. For this purpose, the calibrator 640 is provided with a signal level detector and a phase detector and also holds information on the nominal phase and signal level of the reference signal from the reference signal generator 636. The calibrator 640 then determines a complex gain coefficient $G_{CORR}$ based on the detected changes in signal level and phase of the reference signal, and forwards the calibration coefficient to the complex multiplier 650.

In normal operation, assuming that the complex calibration coefficient has been determined, the switch 635 is operated so that the probed output signal of the power amplifier is transferred over the feedback path. The frequency-down converter 632 and the ADC 634 makes sure that the probed analog output signal $S_{OUT}$ is converted into a digital signal of the same frequency as the original input signal $S_{IN}$. Now, the switch 645 is operated to provide a direct path between the ADC 634 and the complex multiplier 650. The complex multiplier 650 effectuates the calibration by processing the frequency down-converted digital feedback signal and the complex calibration coefficient to provide a calibrated observed signal $S_{OBS}$.

The calibrated observed signal $S_{OBS}$ is then provided to the parameter adaptation block 660, which adapts the predistortion function by updating the look-up table entries of the predistorter 610 based on an analysis of the calibrated observed signal $S_{OBS}$ and a delayed version, using delay block 670, of the input signal $S_{IN}$.

Although the predistorter has been described as a digital predistorter operating at baseband, it should be understood that the predistortion can be applied at radio or intermediate frequencies, known as analog predistortion.

If the phase shift of the feedback path is already maintained or not required to be maintained, it may be sufficient to calibrate the feedback path with respect to gain only to maintain the output power accuracy of the power amplifier system. In this case, the calibrator 640 is provided with an amplitude level detector for measuring the reference signal amplitude/level. The calibrator 640 determines a gain correction coefficient based on the measured signal level and the nominal signal level of the reference signal. The signal compensation or calibration can now be accomplished by combining the normal feedback signal and the correction coefficient in a simple multiplier (no need for a complex multiplier). In this way, the calibration procedure according to the invention keeps the gain $G_{RX}$ of the feedback path constant, while the parameter adaptation of the adaptive predistortion technique is capable of keeping the transmission gain $G_{TX}$ constant. This means that an absolute output power accuracy is obtained.

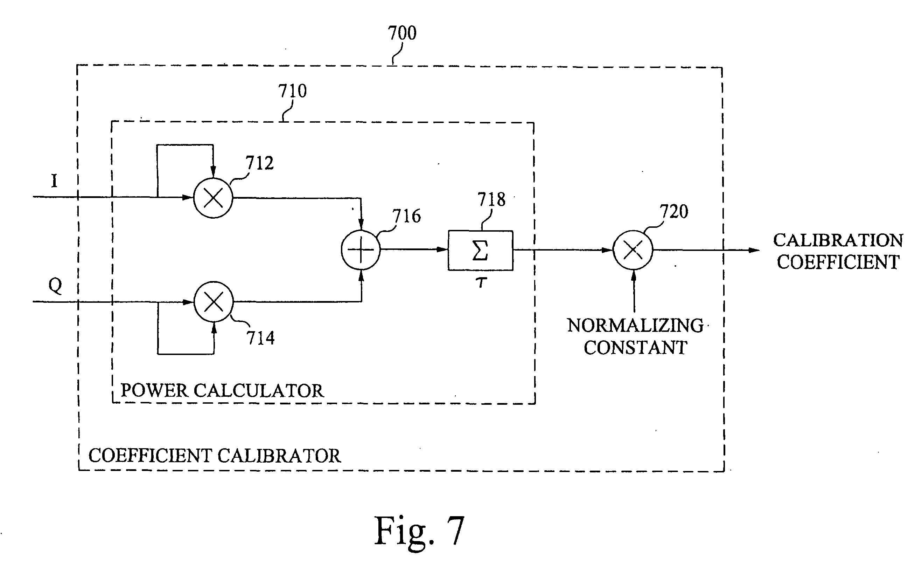

Fig. 7 illustrates an example of a coefficient calibrator for gain calibration of the feedback path of an adaptive signal conditioning system for the purpose of maintaining an absolute output power accuracy. The coefficient calibrator 700 basically comprises a power calculator 710 for calculating the signal power level of the reference signal based on the I- and Q-components of the reference signal, and an output multiplier 720 for multiplying the signal power level with a normalizing constant to produce a calibration coefficient. The power level of the received reference signal is generally calculated by squaring the I- and Q-components using the multipliers 712, 714, summing the squared I- and Q-components in the adder 716 and calculating a mean value of the power level over a given time period in the mean value calculator 718. The resulting signal is then multiplied in the multiplier 720 with the normalizing constant to produce a gain correction coefficient. The normalizing constant takes the nominal reference signal level and the desired gain of the feedback path into account, and would typically be characterized during production. If the reference signal has been converted from analog to digital form over the feedback path, the coefficient calibrator is preferably realized as a completely digital implementation.

A further embodiment is necessary when the feedback path is required to be compensated for gain and phase that are frequency-dependent over the bandwidth of the feedback path. In such a case, the reference signal may be provided in the form of a multitone signal, with a number of tones separated by a fixed frequency offset. These multiple tones must have a known relative gain and phase relationship. Now, the coefficient calculator first calculates the received gain and phase of each individual tone, for example by transforming the received time domain signal into the frequency domain via a Discrete Fourier Transform (DFT). The gain and phase frequency response of the feedback path is determined, and an equalization frequency response is calculated accordingly. The equalization response combined with the feedback path response gives a frequency-independent gain and phase response. In practice, the equalization response is transformed into coefficients to be used in the compensator. Preferably, the compensator is implemented as a Finite Impulse Response (FIR) filter, using a Least Mean Square (LMS) algorithm to calculate the coefficients of the compensating FIR filter from the derived equalization response.

## *Implementation in an adaptive antenna system*

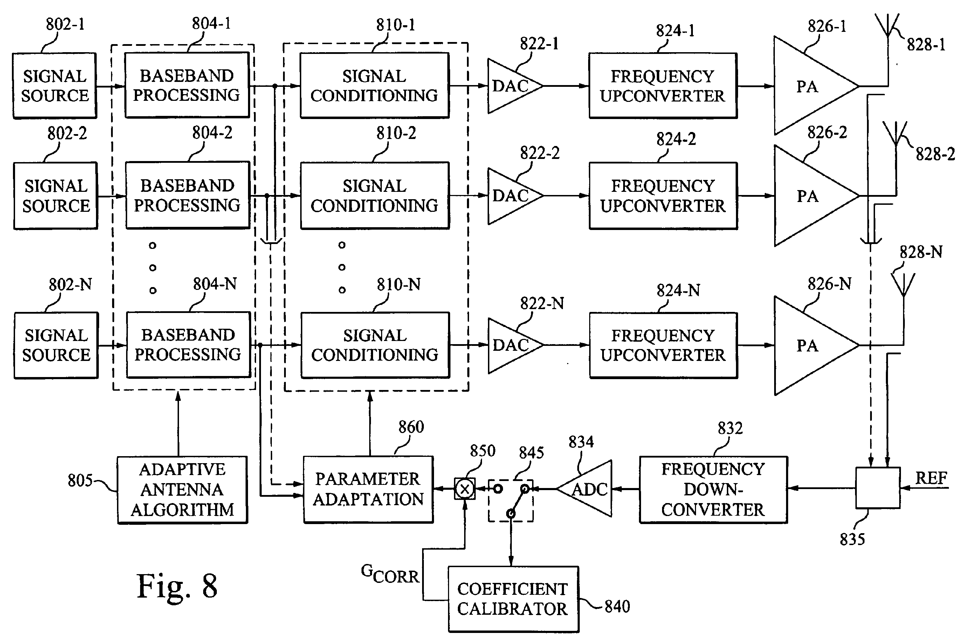

Fig. 8 is a schematic block diagram illustrating an adaptive antenna system according to a preferred embodiment of the invention. The adaptive antenna system of Fig. 8 basically comprises a number, N, of transmission branches. In this example, each transmission branch includes a signal source 802, a baseband processing block 804, a signal conditioning block 810, a digital-to-analog converter 822, a frequency up-converter 824, and a power amplifier 826 connected to an antenna element 828. The antenna elements 828-1 to 828-N form an antenna array. By properly setting the phase and/or amplitude of the transmission signal in each transmission branch using an adaptive antenna algorithm, and simultaneously transmitting the transmission signals from the plurality of antenna elements 828-1 to 828-N, a desired *combined* radiation pattern can be produced by the antenna array. An adaptive antenna algorithm block 805 typically controls the baseband processing blocks 804-1 to 804-N to provide the desired individual transmission signals.

However, the accuracy of the relative linear gain and/or phase between the different transmission branches may be far from optimized (even if the transmission branches are linearized) due to component aging and variations in temperature and transmission frequency during operation as well as difficulties in properly setting the nominal linear gain and phase shift of the transmission branches at production. This means that an adjustment/calibration of the linear gain and/or phase shift of the different transmission branches often is necessary during operation in order to control the relative linear gain and phase accuracy. To this end, a feedback path is normally required to allow adaptation of the parameters used by the signal conditioning blocks 810-1 to 810-N so that the phase and/or amplitude of the transmission signals can be accurately controlled. In the embodiment of Fig. 8, all the antenna-feeding transmission branches alternately share a common feedback path, with a feedback connection from the output of each power amplifier to a switch arrangement 835 in the feedback path. This means that the switch arrangement 835 alternately connects the different transmission branches to the feedback path for allowing adaptation of the transmission signals in turns.

Unfortunately, the gain and/or phase shift of the feedback path is typically also affected by variations in temperature and frequency, and component aging. Therefore, the invention not only proposes adaptive signal conditioning for accurately controlling the phase and/or amplitude of the transmission signals but also the use of a predefined reference signal for recurrently calibrating the feedback path in order to fulfil the requirements on gain and phase accuracy.

For this purpose, the switch arrangement 835 is adapted to selectively switch a reference signal into the feedback path. In addition, the output of the ADC 834 is connected to a further switch 845, which selectively forwards the digital output signal of the ADC 834 either to a coefficient calibrator 840 or a complex multiplier 850. Preferably, the coefficient calibrator 840 operates in a similar manner as the coefficient calibrator of Fig. 6, providing a complex gain correction coefficient $G_{CORR}$ to the complex multiplier 850. The complex multiplier 850 is connected to a parameter adaptation block 860 for providing a calibrated, accurate representation of the output signal of the respective power amplifier to the adaptation block.

The parameter adaptation block 860 compares the calibrated feedback signal with a delayed version (the delay blocks are not explicitly shown in Fig. 8) of the corresponding input signal, and then adapts the operation of the respective signal conditioning block based on the comparison. The parameter adaptation is primarily performed for adjusting the phase and/or amplitude of the transmission signal of the respective transmission branch, but preferably also for predistorting the respective transmission signal for canceling possible distortion and linearizing the output signal of the corresponding power amplifier.

A typical calibration procedure is initiated by operating the switch arrangement 835 to insert the reference signal into the feedback path. The switch arrangement 845 forwards the transferred reference signal to the coefficient calibrator 840, which then determines an appropriate complex gain calibration coefficient for phase and gain calibration.

Preferably, the phase shift for the phase calibration is selected arbitrarily so that the feedback path is given a fixed phase shift anywhere between -180° and 180°. In practice, this means that a phase detector incorporated in the coefficient calibrator measures the phase of the reference signal. The result of the phase measurement is compared to the nominal phase of the reference signal in order to determine the phase shift experienced by the reference signal over the feedback path. The calibrator then sets the complex gain coefficient so that the complex multiplier, or a conventional phase adjuster, adjusts the phase shift of the feedback path towards the selected phase shift.

Once the feedback path has been calibrated, the switch arrangement 835 switches the output signal of the first transmission branch to the calibrated feedback path. The parameter adaptation of the first transmission branch makes sure that the phase shift of the transmission branch is opposite and equal to that of the calibrated feedback path and that the gain of the transmission branch is properly adjusted. Now, the switch arrangement 835 switches the output signal of the next transmission branch into the feedback path, and the corresponding parameter adaptation adjusts the phase shift and gain of the transmission branch. The procedure continues until all transmission branches have the same calibrated phase shift and gain, thus ensuring that the desired phase and amplitude relationship between the transmission signals of the different branches can be accurately maintained.

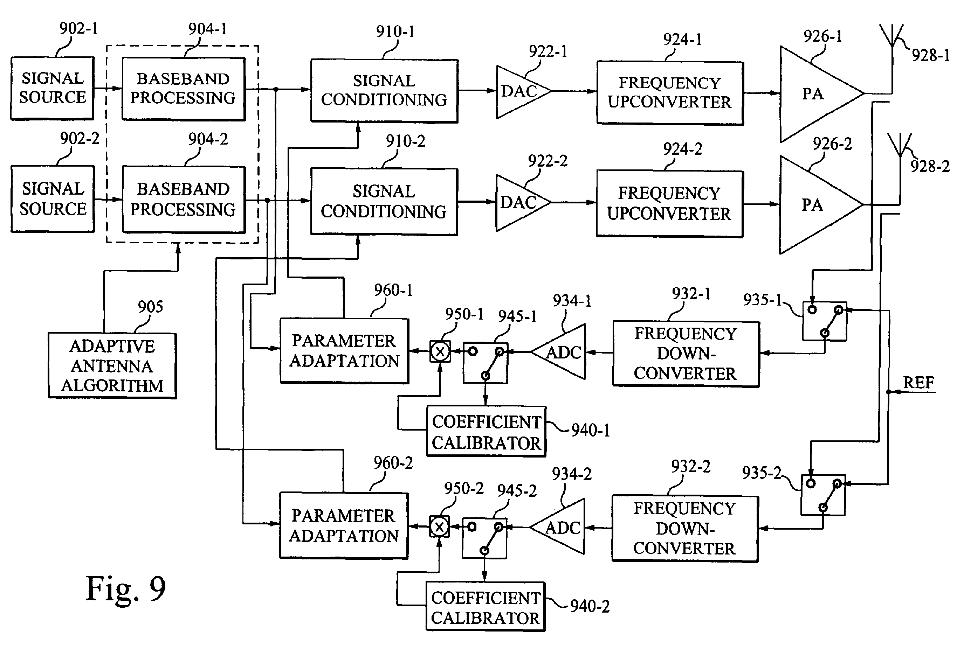

Fig. 9 is a schematic block diagram illustrating an adaptive antenna system according to an alternative embodiment of the invention. The adaptive antenna system of Fig. 9 is similar to that of Fig. 8, except that now each transmission branch (only two branches are illustrated) is associated with its own dedicated feedback path and parameter adaptation block. This means that the first transmission branch defined by signal source 902-1, baseband processing block 904-1, signal conditioning block 910-1, DAC 922-1, up-converter 924-1, amplifier 926-1 has its own feedback path, defined by switch 935-1, down-converter 932-1, ADC 934-1, switch 945-1, coefficient calibrator 940-1 and complex multiplier 950-1, leading to the parameter adaptation block 960-1. Similarly, the second transmission branch defined by signal source 902-2, baseband processing block 904-2, signal conditioning block 910-2, DAC 922-2, up-converter 924-2, amplifier 926-2 has its own feedback path, defined by switch 935-2, down-converter 932-2, ADC 934-2, switch 945-2, coefficient calibrator 940-2 and complex multiplier 950-2, leading to the parameter adaptation block 960-2. With this kind of arrangement, it is beneficial if all feedback paths are calibrated to the same absolute phase and/or gain using the same reference signal.

### Implementation in a transmit diversity system

For a transmit diversity system used in a mobile communication system such as WCDMA (Wideband Code Division Multiple Access), the downlink signal is often transmitted via two or more base station antenna transmission branches, utilizing either space or polarization diversity.

The performance gain from transmit diversity, generally reflected as improved downlink capacity, can be subdivided into coherent combining gain and diversity gain against fast fading. The coherent combining gain is obtained because the signals transmitted by the antenna branches are combined coherently, while interference is combined non-coherently. The gain from ideal coherent combining is 3 dB with two antennas. Transmit diversity also provides gain against fast fading. This gain is larger when there is less multipath diversity. In this respect, it is important to note the difference between multipath diversity and transmit diversity. In CDMA, multipath diversity reduces the orthogonality of the downlink codes, while transmit diversity keeps the downlink codes orthogonal in flat fading channels. In order to maximize the interference-limited downlink capacity, it would be beneficial to avoid multipath propagation to keep the codes orthogonal and to provide diversity with transmit antenna diversity. The transmit diversity gain can alternatively be used to improve the downlink coverage, while keeping the load unchanged.

The antenna branches used in a transmit diversity system have strict requirements on the delay matching. If these requirements are not satisfactorily fulfilled, the capacity gain achieved by the transmit diversity could be lost, or worse it could actually degrade the system capacity.

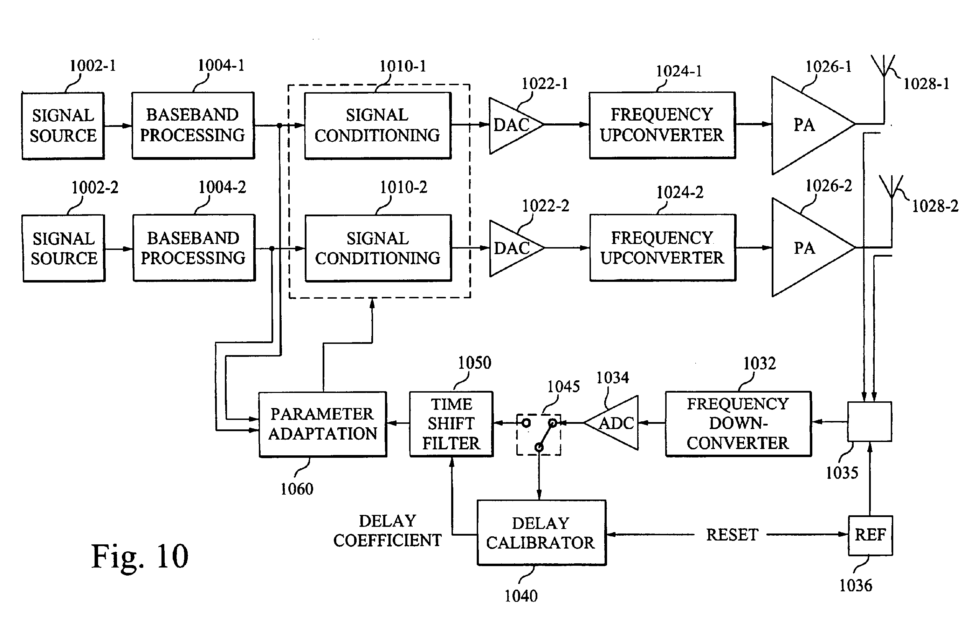

Fig. 10 is a schematic block diagram illustrating a transmit diversity system according to a preferred embodiment of the invention. The transmit diversity system of Fig. 10 basically comprises two (or more) antenna transmission branches. In this example, each antenna transmission branch includes a signal source 1002, a baseband processing block 1004, a signal conditioning block 1010, a digital-to-analog converter 1022, a frequency up-converter 1024 and a power amplifier 1026 connected to an antenna element 1028. The signal conditioning block 1010 now includes a time shift filter, and the corresponding parameter adaptation has to determine the necessary delay adjustment for the transmission branch. In this particular example, the transmission branches share the same feedback path. A switch arrangement 1035 is provided for alternately connecting the different transmission branches to the feedback path, or for selectively switching a reference signal from a reference signal generator 1036 into the feedback path. The feedback path basically comprises a frequency down-converter 1032 and an ADC 1034. The output of the ADC 1034 is connected to a further switch 1045, which selectively forwards the digital output signal of the ADC 1034 either to a delay calibrator 1040 or a time shift filter 1050. The time shift filter 1050 is connected to a parameter adaptation block 1060 for providing a delay-calibrated representation of the output signal of the respective power amplifier to the adaptation block. In the case of delay calibration, the parameter adaptation is primarily performed for adjusting the delay of the transmission signal of the respective transmission branch in the signal conditioning block 1010 to ensure accurate delay matching between the different transmission branches.

For delay calibration of the feedback path, the reference signal generator 1036 and the delay calibrator 1040 are synchronized in time by means of a reset signal so that they both work from the same time reference. It is also important that the reference signal contains information that makes it possible to differentiate time. For example, the reference signal may be provided as a band-limited spread spectrum signal that can be de-correlated in the delay calibrator 1040 to resolve the time delay of the feedback path. The calibrator 1040 calculates a delay correction coefficient and the time shift filter 1050 adjusts the delay of the feedback path to a known fixed time delay. This means that the absolute time delay of each transmission branch can be calculated.

Once the feedback path has been calibrated to a fixed delay, the switch arrangement 1035 alternately connects the different transmission branches to the calibrated feedback path. In this way, the delay of the different transmission branches can be accurately adjusted by the corresponding parameter adaptation such that the desired delay relationship between the transmission signals of the different branches is maintained.

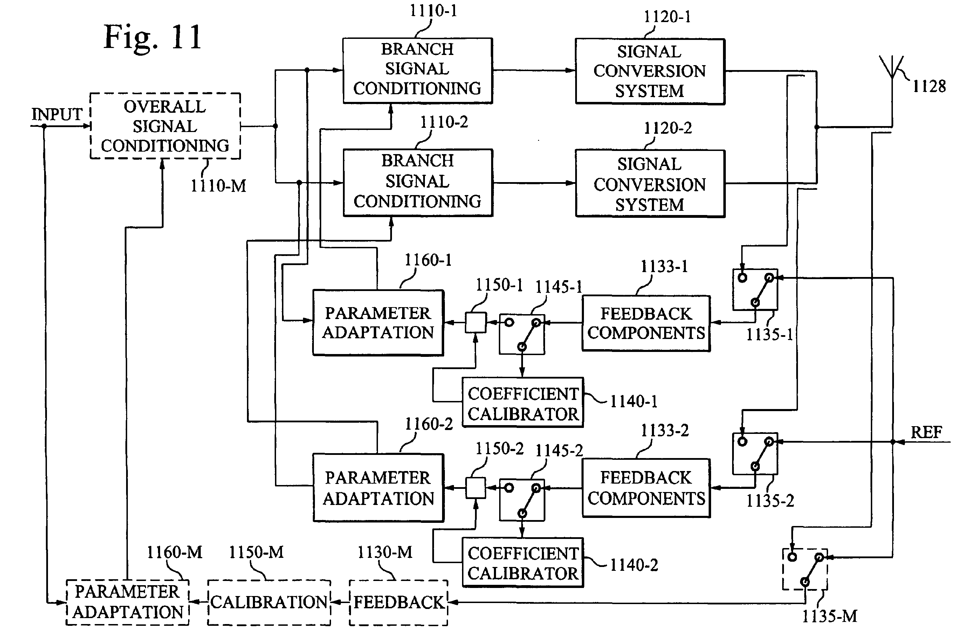

Fig. 11 is a schematic block diagram illustrating yet another multi-branch transmitter system according to the invention. Instead of having a single transmission branch for each antenna, as shown in Figs. 8-10, two or more transmission branches are now combined to produce the output signal for transmission by an antenna. In this example, an input signal path is divided into two or more transmission branches, possibly after optional signal conditioning in the overall signal conditioning block 1110-M. Each individual transmission branch typically includes a branch signal conditioning block 1110 and signal conversion system 1120. The output signals of the different transmission branches are generally combined, either directly or over some type of output network (not shown), into a common signal for transmission by the antenna 1128. Each transmission branch is associated with a feedback path for enabling adaptation of the parameters used by the respective branch signal conditioning block. By selectively switching, using switch 1135, a reference signal into the feedback path, the feedback path may be calibrated by means of the further switch 1145, the coefficient calibrator 1140 and the compensator 1150, as described earlier. This allows more accurate adaptive signal conditioning, and better control of the gain, phase and/or delay relationship between the transmission signals of the different transmission branches.

It is also possible to provide a feedback path for allowing adaptation of the parameters used by the overall signal conditioning block 1110-M, and calibrating this feedback path using the reference signal. In this case, the reference signal is inserted into the feedback path by the switch 1135-M, and transferred over the required feedback components 1130-M and calibrated in the calibration block 1150-M. The calibration block 1150-M generally comprises the same functional units 1140, 1145, 1150 as the calibration mechanism for each individual feedback path. This means that the parameter adaptation block 1160-M for the overall signal conditioning block 1110-M receives a calibrated feedback signal.

The architecture illustrated in Fig. 11 is particularly suitable for use with efficiency enhancement techniques such as Doherty, Chireix, EER (Envelope Elimination and Restoration), Bias Adaptation and other similar techniques for accurately controlling the gain, phase and or delay relationship between the different transmission branches in the system. For example, in the case of a Doherty-based system, one of the transmission branches includes the main amplifier, whereas the other transmission branch includes an auxiliary amplifier and the output signals of the different transmission branches are combined over a Doherty output network. Detailed information on efficiency enhancement techniques in connection with RF power amplifiers can be found, for example in reference [15]. Although the techniques are not explicitly shown as adaptive in reference [15], the extension from non-adaptive to adaptive efficiency enhancement techniques is quite straightforward in view of the present disclosure.

The embodiments described above are merely given as examples, and it should be understood that the present invention is not limited thereto. For example, various hybrids of the illustrated embodiments can be realized.

## REFERENCES

[1]    R. C. Davis and J. Grabowski, "An Experimental MQAM Modem Using Amplifier Linearization and Baseband Equalization Techniques", Proc. Natl. Commun. Conf., pp. E3.2.1-E3.2.6, 1982.

[2]    U.S. Patent No. 4,291,277.

[3]    U.S. Patent No. 5,483,681.

[4]    U.S. Patent No. 5,937,011.

[5]    U.S. Patent No. 5,909,642.

[6]    U.S. Patent No. 6,072,364.
[7]    U.S. Patent No. 6,141,390.
[8]    International Patent Application WO 97/49174.
[9]    European Patent Application No. 1,047,185.
[10]   U.S. Patent No. 4,462,001.
[11]   U.S. Patent No. 4, 700,151.
[12]   U.S. Patent No. 5,049,832.
[13]   X. Vuong, H. Moody, "Realization of Predistortion Compensators of Memoryless Nonlinear Devices", Spar Aerospace, 1980.
[14]   Saleh, Salz, "Adaptive Linearization of Power Amplifiers", Bell Journal, Bell Labs, April 1983.
[15]   S. C. Cripps, "RF Power Amplifiers for Wireless Communications", Artech House, 1999, pp. 219-250.

**Claims**

1. An adaptive signal conditioning system comprising a signal conditioner (210; 310; 610; 810; 910; 1010; 1110) in the signal path to a signal conversion system (220; 320; 620; 822-826; 922-926; 1022-1026; 1120), and a feedback path responsive to the output signal of said signal conversion system to enable adaptation of parameters used by the signal conditioner,

   **characterized in that** said signal conditioning system further comprises:

   - means for selectively inserting a reference signal into said feedback path;
   - means (240, 250; 340, 350; 640, 650; 840, 850; 940, 950; 1040, 1050; 1140, 1150) for calibrating said feedback path based on said reference signal, wherein said calibrating means comprises:

      means for measuring signal characteristics at the output of said feedback path in response to said inserted reference signal;
      means (240) for determining a correction coefficient set based on the measured signal characteristics and nominal signal characteristics of said inserted reference signal;
      means (250) for calibrating said feedback path based on said correction coefficient set;

   wherein said signal conditioning system further comprises a reference signal compensator (520) for adjusting said reference signal according to commands from a signal adjustment controller (530) to maintain the nominal signal characteristics of said reference signal.

2. The adaptive signal conditioning system according to claim 1, **characterized in that** said calibrating means calibrates said feedback path with respect to at least one of gain, phase shift and delay.

3. The adaptive signal conditioning system according to claim 1 or 2, **characterized in that** said reference signal inserting means comprises means (335; 635; 835; 935; 1035; 1135) for selectively switching the reference signal into said feedback path instead of the output signal of said signal conversion system.

4. The adaptive signal conditioning system according to claim 1, **characterized in that** said calibrating means comprises means (250; 350; 650; 850; 950; 1050; 1150) for compensating for changes in transfer characteristics of said feedback path based on measurements of changes in signal characteristics of said reference signal over said feedback path.

5. The adaptive signal conditioning system according to claim 1, **characterized in that** said reference signal compensator (520) is configured for performing the signal adjustment based on pre-characterization of the reference signal characteristics with respect to at least one of the variables temperature, frequency and time.

6. The adaptive signal conditioning system according to claim 1, **characterized in that** said reference signal compensator (520) is configured for performing the signal adjustment based on direct measurements of the signal characteristics of the reference signal.

7. The adaptive signal conditioning system according to any of the claims 1-6, **characterized in that** the signal characteristics include at least one of signal level, signal phase and signal delay.

8. The adaptive signal conditioning system according to claim 1, **characterized in that** said signal conditioning system comprises multiple signal conditioners (810; 910; 1010; 1110), each of which is provided in the signal path to a respective signal conversion system, each one of said signal conditioners being associated with a reference-signal-calibrated feedback path from the output of the respective signal conversion system to enable adaptation of parameters used by the signal conditioner.

9. The adaptive signal conditioning system according to claim 1, **characterized in that** said feedback path extends from the output of said signal conversion system (220; 320; 620; 822-826; 922-926; 1022-1026; 1120) to a parameter adaptation block (260; 360; 660; 860; 960; 1060; 1160), and said parameter adaptation block is operable for adapting the signal conditioner parameters in response to a feedback signal transferred over the calibrated feedback path and an input signal representation.

10. The adaptive signal conditioning system according to any of the preceding claims, **characterized in that** said reference signal comprises multiple signal components.

11. A calibration method for an adaptive signal conditioning system having a signal conditioner provided in the signal path to a signal conversion system, and a feedback path responsive to the output signal of the signal conversion system to enable adaptation of parameters used by the signal conditioner,
**characterized in that** said method comprises the steps of:

- selectively inverting (401) a reference signal into said feedback path; and
- calibrating (402-404) said feedback path based on said reference signal, wherein said calibrate step comprises the steps of:

measuring signal characteristics at the output of said feedback path in response to said inserted reference signal;
determining a correction coefficient set based on the measured signal characteristics and nominal signal characteristics of said inserted reference signal;
calibrating said feedback path based on said correction coefficient set;

wherein said calibration method further comprises the step of adjusting said reference signal according to commands from a signal adjustment controller (530) to maintain the nominal signal characteristics of said reference signal.

12. The calibration method according to claim 11,
**characterized in that** said feedback path is calibrated with respect to at least one of gain, phase shift and delay.

13. The calibration method according to claim 11 or 12,
**characterized in that** said reference signal inserting step comprises the step of selectively switching the reference signal into said feedback path instead of the output signal of said signal conversion system.

14. The calibration method according to claim 11,
**characterized in that** said calibrating step comprises the step (404) of compensating for changes in transfer characteristics of said feedback path based on measurements (402) of changes in signal characteristics of said reference signal over said feedback path.

15. The calibration method according to claim 11,
**characterized in that** said step of adjusting said reference signal comprises the step of maintaining the nominal signal characteristics of said inserted reference signal based on pre-characterization of the reference signal characteristics with respect to at least one of the variables temperature and frequency.

16. The calibration method according to claim 11,
**characterized in that** step of adjusting said reference signal comprises the step of maintaining the nominal signal characteristics of said reference signal based on direct measurements of the signal characteristics of the reference signal.

17. The calibration method according to any of the claims 11-16,
**characterized in that** the signal characteristics include at least one of signal level, signal phase and signal delay.

**18.** A power amplifier system comprising an adaptive signal conditioning system according to any of the claims 1-10.

**19.** The power amplifier system of claim 18, wherein said signal conditioning system includes a predistorter in the signal path to a power amplifier of the power amplifier system, and said calibrating means is configured for calibrating said feedback path with respect to gain for enabling adaptation of the predistorter parameters with respect to signal level such that the output power accuracy of the power amplifier system is maintained.

**20.** A transmitter system comprising an adaptive signal conditioning system according to any of the claims 1-10.

**21.** The transmitter system according to claim 20, wherein said transmitter system comprises:

- multiple signal transmission branches (802-826; 902-926; 1002-1026; 1110, 1120), each of which includes a signal conditioner (810; 910; 1010; 1110); and
- at least one feedback path responsive to the output signal of at least one transmission branch to enable adaptation of parameters used by the corresponding signal conditioner;

wherein said reference signal is inserted into said at least one feedback path for calibration thereof.

**22.** The transmitter system according to claim 21,
**characterized in that** said transmission branches alternately share a common feedback path, with a feedback connection from the output of each transmission branch to said common feedback path, and that said reference signal is inserted into said common feedback path for calibration thereof.

**23.** The transmitter system according to claim 21,
**characterized in that** each transmission branch is associated with its own feedback path, and that all feedback paths are calibrated using the same reference signal.

**24.** The transmitter system according to claim 21,
**characterized in that** said transmitter system is an adaptive antenna system, and that said calibrating means calibrates said at least one feedback path with respect to at least one of gain and phase shift.

**25.** The transmitter system according to claim 21,
**characterized in that** said transmitter system is a transmit diversity system, and that said calibrating means calibrates said at least one feedback path with respect to delay for enabling adaptation of the parameters used by the signal conditioners in the transmission branches such that the accuracy of the delay matching between the transmission branches is maintained.

**26.** The transmitter system according to claim 21,
**characterized in that** each of said transmission branches comprises a power amplifier in the input signal path to an antenna (828; 928; 1028).

**27.** The transmitter system according to claim 21,
**characterized in that** each transmission branch is associated with its own antenna (828; 928; 1028).

**28.** The transmitter system according to claim 21,
**characterized in that** a number of said transmission branches are combined to produce an output signal for transmission by an antenna (1128).

**Patentansprüche**

**1.** Adaptives Signalformungssystem, umfassend einen Signalformer (210; 310; 610; 810; 910; 1010; 1110) im Signalweg zu einem Signalumsetzungssystem (220; 320; 620; 822-826; 922-926; 1022-1026; 1120) und einen Rückkopplungsweg, der auf das Ausgangssignal des Signalumsetzungssystems anspricht, um die Anpassung von Parametern zu ermöglichen, die durch den Signalformer verwendet werden,
**dadurch gekennzeichnet, dass** das Signalformungssystem ferner umfasst:

Mittel zum selektiven Einfügen eines Bezugssignals in den Rückkopplungsweg;

Mittel (240, 250; 340, 350; 640, 650; 840, 850; 940, 950; 1040, 1050; 1140, 1150) zum Kalibrieren des Rückkopplungsweges auf der Grundlage des Bezugssignals;

wobei die Kalibriermittel umfassen:

Mittel zum Messen von Signalkennwerten am Ausgang des Rückkopplungsweges als Antwort auf das eingefügte Bezugssignal;
Mittel (240) zum Bestimmen einer Korrekturkoeffizientenmenge auf der Grundlage der gemessenen Signalkennwerte und von Nennsignalkennwerten des eingefügten Bezugssignals;
Mittel (250) zum Kalibrieren des Rückkopplungsweges auf der Grundlage der Korrekturkoeffizientenmenge;

wobei das Signalumsetzungssystem ferner einen Bezugssignalkompensator (520) zum Einstellen des Bezugssignals gemäß Befehlen von einer Signaleinstellungs-Steuerschaltung (530), um die Nennsignalkennwerte des Bezugssignals beizubehalten, umfasst.

2. Adaptives Signalformungssystem nach Anspruch 1, **dadurch gekennzeichnet, dass** die Kalibriermittel den Rückkopplungsweg in Bezug auf Verstärkung und/oder Phasenverschiebung und/oder Verzögerung kalibrieren.

3. Adaptives Signalformungssystem nach Anspruch 1 oder 2, **dadurch gekennzeichnet, dass** die Bezugssignaleinführmittel Mittel (335; 635; 835; 935; 1035; 1135) zum selektiven Schalten des Bezugssignals in den Rückkopplungsweg anstelle des Ausgangssignals des Signalumsetzungssystems umfassen.

4. Adaptives Signalformungssystem nach Anspruch 1, **dadurch gekennzeichnet, dass** die Kalibriermittel Mittel (250; 350; 650; 850; 950; 1050; 1150) zum Kompensieren von Veränderungen der Übertragungskennlinie des Rückkopplungsweges auf der Grundlage von Messungen von Veränderungen in den Signalkennwerten des Bezugssignals auf dem Rückkopplungsweg umfassen.

5. Adaptives Signalformungssystem nach Anspruch 1, **dadurch gekennzeichnet, dass** der Bezugssignalkompensator (520) dafür konfiguriert ist, die Signaleinstellung auf der Grundlage einer Vorcharakterisierung der Bezugssignalkennwerte in Bezug auf mindestens eine der folgenden Variablen vorzunehmen, nämlich Temperatur, Frequenz und Zeit.

6. Adaptives Signalformungssystem nach Anspruch 1, **dadurch gekennzeichnet, dass** der Bezugssignalkompensator (520) dafür konfiguriert ist, die Signaleinstellung auf der Grundlage von direkten Messungen der Signalkennwerte des Bezugssignals vorzunehmen.

7. Adaptives Signalformungssystem nach einem der Ansprüche 1-6, **dadurch gekennzeichnet, dass** die Signalkennwerte Signalpegel und/oder Signalphase und/oder Signalverzögerung aufweisen.

8. Adaptives Signalformungssystem nach Anspruch 1, **dadurch gekennzeichnet, dass** das Signalformungssystem mehrere Signalformer (810; 910; 1010; 1110) umfasst, deren jeder im Signalweg einem jeweiligen Signalumsetzungssystem bereitgestellt wird, wobei jedem der Signalformer ein bezugssignalkalibrierter Rückkopplungsweg vom Ausgang des jeweiligen Signalumsetzungssystems zugeordnet ist, um eine Anpassung von Parametern zu ermöglichen, die durch den Signalformer verwendet werden.

9. Adaptives Signalformungssystem nach Anspruch 1, **dadurch gekennzeichnet, dass** der Rückkopplungsweg vom Ausgang des Signalumsetzungssystems (220; 320; 620; 822-826; 922-926; 1022-1026; 1120) zu einem Parameteranpassungsblock (260; 360; 660; 860; 960; 1060; 1160) verläuft und der Parameteranpassungsblock zur Anpassung der Signalformerparameter als Antwort auf ein über den kalibrierten Rückkopplungsweg übertragenes Rückkopplungssignal und eine Eingangssignaldarstellung betriebsfähig ist.

10. Adaptives Signalformungssystem nach einem der vorhergehenden Ansprüche, **dadurch gekennzeichnet, dass** das Bezugssignal mehrere Signalkomponenten umfasst.

11. Kalibrierverfahren für ein adaptives Signalformungssystem mit einem Signalformer, der im Signalweg einem Signalumsetzungssystem bereitgestellt wird, und einem Rückkopplungsweg, der auf das Ausgangssignal des Signalumsetzungssystems anspricht, um eine Anpassung von Parametern zu ermöglichen, die durch den Signalformer verwendet werden,

**dadurch gekennzeichnet, dass** das Verfahren die folgenden Schritte umfasst:

selektives Einfügen (401) eines Bezugssignals in den Rückkopplungsweg; und
Kalibrieren (402-404) des Rückkopplungsweges auf der Grundlage des Bezugssignals,

wobei der Kalibrierschritt die folgenden Schritte umfasst:

Messen von Signalkennwerten am Ausgang des Rückkopplungsweges als Antwort auf das eingefügte Bezugssignal;
Bestimmen einer Korrekturkoeffizientenmenge auf der Grundlage der gemessenen Signalkennwerte und von Nennsignalkennwerten des eingefügten Bezugssignals;
Kalibrieren des Rückkopplungsweges auf der Grundlage der Korrekturko effizientenmenge;

wobei das Kalibrierverfahren ferner den Schritt umfasst: Einstellen des Bezugssignals gemäß Befehlen von einer Signaleinstellungs-Steuerschaltung (530), um die Nennsignalkennwerte des Bezugssignals beizubehalten.

12. Kalibrierverfahren nach Anspruch 11, **dadurch gekennzeichnet, dass** der Rückkopplungsweg in Bezug auf Verstärkung und/oder Phasenverschiebung und/oder Verzögerung kalibriert wird.

13. Kalibrierverfahren nach Anspruch 11 oder 12, **dadurch gekennzeichnet, dass** der Bezugssignal-Einfügungsschritt den Schritt umfasst: Selektives Schalten des Bezugssignals in den Rückkopplungsweg anstelle des Ausgangssignals des Signalumsetzungssystems.

14. Kalibrierverfahren nach Anspruch 11, **dadurch gekennzeichnet, dass** der Kalibrierschritt den Schritt (404) umfasst: Kompensieren von Veränderungen in der Übertragungskennlinie des Rückkopplungsweges auf der Grundlage von Messungen (402) von Veränderungen in den Signalkennwerten des Bezugssignals auf dem Rückkopplungsweg.

15. Kalibrierverfahren nach Anspruch 11, **dadurch gekennzeichnet, dass** der Schritt des Einstellens des Bezugssignals den Schritt umfasst: Beibehalten der Nennsignalkennwerte des eingefügten Bezugssignals auf der Grundlage einer Vorcharakterisierung der Bezugssignalkennwerte in Bezug auf mindestens eine der folgenden Variablen, nämlich Temperatur und Frequenz.

16. Kalibrierverfahren nach Anspruch 11, **dadurch gekennzeichnet, dass** der Schritt des Einstellens des Bezugssignals den Schritt umfasst: Beibehalten der Nennsignalkennwerte des eingefügten Bezugssignals auf der Grundlage von direkten Messungen der Signalkennwerte des Bezugssignals.

17. Kalibrierverfahren nach einem der Ansprüche 11-16, **dadurch gekennzeichnet, dass** die Signalkennwerte Signalpegel und/oder Signalphase und/oder Signalverzögerung aufweisen.

18. Leistungsverstärkersystem, umfassend ein adaptives Signalformungssystem nach einem der Ansprüche 1-10.

19. Leistungsverstärkersystem nach Anspruch 18, wobei das Signalformungssystem einen Vorverzerrer im Signalweg zu einem Leistungsverstärker des Leistungsverstärkersystems aufweist und die Kalibriermittel zur Kalibrierung des Rückkopplungsweges in Bezug auf die Verstärkung konfiguriert sind, um eine Anpassung der Vorverzerrerparameter in Bezug auf den Signalpegel zu ermöglichen, so dass die Ausgangsleistungsgenauigkeit des Leistungsverstärkersystems beibehalten wird.

20. Sendersystem, umfassend ein adaptives Signalformungssystem nach einem der Ansprüche 1-10.

21. Sendersystem nach Anspruch 20, wobei das Sendersystem umfasst:

mehrere Signalübertragungszweige (802-826; 902-926; 1002-1026; 1110, 1120), deren jeder einen Signalformer (810; 910; 1010; 1110) aufweist; und
mindestens einen Rückkopplungsweg, der auf das Ausgangssignal mindestens eines Übertragungszweiges anspricht, um die Anpassung von Parametern zu ermöglichen, die durch den jeweiligen Signalformer verwendet werden;
wobei das Bezugssignal in den mindestens einen Rückkopplungsweg zur Kalibrierung desselben eingefügt wird.

22. Sendersystem nach Anspruch 21, **dadurch gekennzeichnet, dass** die Übertragungszweige einen gemeinsamen Rückkopplungsweg abwechselnd gemeinsam nutzen, und zwar mit einer Rückkopplungsverbindung vom Ausgang jedes Übertragungszweiges zu dem gemeinsamen Rückkopplungsweg, und dass das Bezugssignal in den gemeinsamen Rückkopplungsweg zur Kalibrierung desselben eingefügt wird.

23. Sendersystem nach Anspruch 21, **dadurch gekennzeichnet, dass** jedem Übertragungszweig sein eigener Rückkopplungsweg zugeordnet ist und dass alle Rückkopplungswege unter Verwendung desselben Bezugssignals kalibriert werden.

24. Sendersystem nach Anspruch 21, **dadurch gekennzeichnet, dass** das Sendersystem ein System mit adaptiven Antennen ist und dass die Kalibriermittel den mindestens einen Rückkopplungsweg in Bezug auf Verstärkung und/ oder Phasenverschiebung kalibrieren.

25. Sendersystem nach Anspruch 21, **dadurch gekennzeichnet, dass** das Sendersystem ein System mit Sendediversity ist und dass die Kalibriermittel den mindestens einen Rückkopplungsweg in Bezug auf die Verzögerung kalibrieren, um die Anpassung der Parameter zu ermöglichen, die durch die Signalformer in den Übertragungszweigen verwendet werden, so dass die Genauigkeit der Verzögerungsanpassung zwischen den Übertragungszweigen beibehalten wird.

26. Sendersystem nach Anspruch 21, **dadurch gekennzeichnet, dass** jeder der Übertragungszweige einen Leistungsverstärker im Eingangssignalweg zu einer Antenne (828; 928; 1028) umfasst.

27. Sendersystem nach Anspruch 21, **dadurch gekennzeichnet, dass** jedem Übertragungszweig seine eigene Antenne (828; 928; 1028) zugeordnet ist.

28. Sendersystem nach Anspruch 21, **dadurch gekennzeichnet, dass** eine Anzahl der Übertragungszweige kombiniert wird, um ein Ausgangssignal zur Übertragung durch eine Antenne (1128) zu erzeugen.

**Revendications**

1. Système adaptatif de conditionnement de signaux, comprenant un conditionneur de signaux (210; 310; 610; 810; 910; 1010; 1110) sur le chemin de signal menant à un système de conversion de signaux (220; 320; 620; 822 - 826; 922 - 926; 1022 - 1026; 1120), et un chemin de retour sensible au signal de génération en sortie dudit système de conversion de signaux en vue de permettre une adaptation de paramètres utilisés par le conditionneur de signaux; **caractérisé en ce que** ledit système de conditionnement de signaux comprend en outre:

   - un moyen pour insérer de manière sélective un signal de référence dans ledit chemin de retour;
   - un moyen (240, 250; 340, 350; 640, 650; 840, 850; 940, 950; 1040, 1050; 1140, 1150) pour étalonner ledit chemin de retour sur la base dudit signal de référence;

   dans lequel ledit moyen d'étalonnage comprend:

   un moyen pour mesurer des caractéristiques de signal au niveau de la sortie dudit chemin de retour en réponse audit signal de référence inséré;
   un moyen (240) pour déterminer un ensemble de coefficients de correction sur la base des caractéristiques de signal mesurées et des caractéristiques de signal nominales dudit signal de référence inséré;
   un moyen (250) pour étalonner ledit chemin de retour sur la base dudit ensemble de coefficients de correction;
   dans lequel ledit système de conditionnement de signaux comprend en outre un compensateur de signaux de référence (520) pour ajuster ledit signal de référence selon des commandes en provenance d'un contrôleur d'ajustement de signaux (530) destinées à maintenir les caractéristiques de signal nominales dudit signal de référence.

2. Système adaptatif de conditionnement de signaux selon la revendication 1, **caractérisé en ce que** ledit moyen d'étalonnage étalonne ledit chemin de retour relativement à un gain et/ou un déphasage et/ou un retard.

3. Système adaptatif de conditionnement de signaux selon la revendication 1 ou 2, **caractérisé en ce que** ledit moyen d'insertion de signal de référence comprend un moyen (335; 635; 835; 935; 1035; 1135) pour commuter de manière sélective le signal de référence dans ledit chemin de retour au lieu du signal de génération en sortie dudit système de conversion de signaux.

4. Système adaptatif de conditionnement de signaux selon la revendication 1, **caractérisé en ce que** ledit moyen d'étalonnage comprend un moyen (250; 350; 650; 850; 950; 1050; 1150) pour compenser les modifications au niveau des caractéristiques de transfert dudit chemin de retour sur la base de mesures de modifications au niveau des caractéristiques de signal dudit signal de référence sur ledit chemin de retour.

5. Système adaptatif de conditionnement de signaux selon la revendication 1, **caractérisé en ce que** ledit compensateur de signaux de référence (520) est configuré de manière à mettre en oeuvre l'ajustement de signal sur la base d'une pré-caractérisation des caractéristiques de signal de référence relativement à une température et/ou une fréquence et/ou un temps.

6. Système adaptatif de conditionnement de signaux selon la revendication 1, **caractérisé en ce que** ledit compensateur de signaux de référence (520) est configuré de manière à mettre en oeuvre l'ajustement de signal sur la base de mesures directes des caractéristiques de signal du signal de référence.

7. Système adaptatif de conditionnement de signaux selon l'une quelconque des revendications 1 à 6, **caractérisé en ce que** les caractéristiques de signal incluent un niveau de signal et/ou une phase de signal et/ou un retard de signal.

8. Système adaptatif de conditionnement de signaux selon la revendication 1, **caractérisé en ce que** ledit système de conditionnement de signaux comprend de multiples conditionneurs de signaux (810; 910; 1010; 1110), dont chacun est délivré sur le chemin de signal à un système de conversion de signaux respectif, chacun desdits conditionneurs de signaux étant associé à un chemin de retour de signaux de référence étalonné en provenance de la sortie du système de conversion de signaux respectif, pour permettre une adaptation de paramètres utilisés par le conditionneur de signaux.

9. Système adaptatif de conditionnement de signaux selon la revendication 1, **caractérisé en ce que** ledit chemin de retour s'étend de la sortie dudit système de conversion de signaux (220; 320; 620; 822 - 826; 922 - 926; 1022 - 1026; 1120) à un bloc d'adaptation de paramètres (260; 360; 660; 860; 960; 1060; 1160), et ledit bloc d'adaptation de paramètres est exploitable pour adapter les paramètres de conditionneurs de signaux en réponse à un signal de contre-réaction transféré sur le chemin de retour étalonné et à une représentation de signal d'entrée.

10. Système adaptatif de conditionnement de signaux selon l'une quelconque des revendications précédentes, **caractérisé en ce que** ledit signal de référence comprend de multiples composantes de signal.

11. Procédé d'étalonnage destiné à un système adaptatif de conditionnement de signaux présentant un conditionneur de signaux délivré sur le chemin de signal à un système de conversion de signaux, et un chemin de retour sensible au signal de génération en sortie du système de conversion de signaux pour permettre une adaptation de paramètres utilisés par le conditionneur de signaux, **caractérisé en ce que** ledit procédé comprend les étapes ci-dessous consistant à:

- insérer de manière sélective (401) un signal de référence dans ledit chemin de retour; et
- étalonner (402 - 404) ledit chemin de retour sur la base dudit signal de référence,

dans lequel ladite étape d'étalonnage comporte les étapes ci-après consistant à:

mesurer des caractéristiques de signal au niveau de la sortie dudit chemin de retour en réponse audit signal de référence inséré;
déterminer un ensemble de coefficients de correction sur la base des caractéristiques de signal mesurées et des caractéristiques de signal nominales dudit signal de référence inséré;
étalonner ledit chemin de retour sur la base dudit ensemble de coefficients de correction;
dans lequel ledit procédé d'étalonnage comprend en outre l'étape consistant à ajuster ledit signal de référence selon des commandes en provenance d'un contrôleur d'ajustement de signaux (530) pour maintenir les caractéristiques de signal nominales dudit signal de référence.

12. Procédé d'étalonnage selon la revendication 11, **caractérisé en ce que** ledit chemin de retour est étalonné relativement à un gain et/ou un déphasage et/ou un retard.

13. Procédé d'étalonnage selon la revendication 11 ou 12, **caractérisé en ce que** l'étape d'insertion de signal de référence comprend l'étape consistant à commuter de manière sélective le signal de référence dans ledit chemin de retour au lieu du signal de génération en sortie dudit système de conversion de signaux.

14. Procédé d'étalonnage selon la revendication 11, **caractérisé en ce que** ladite étape d'étalonnage comporte l'étape (404) consistant à compenser les modifications au niveau des caractéristiques de transfert dudit chemin de retour sur la base de mesures (402) de modifications au niveau des caractéristiques de signal dudit signal de référence sur ledit chemin de retour.

15. Procédé d'étalonnage selon la revendication 11, **caractérisé en ce que** ladite étape d'ajustement dudit signal de référence comprend l'étape consistant à maintenir les caractéristiques de signal nominales dudit signal de référence inséré sur la base d'une pré-caractérisation des caractéristiques de signal de référence relativement à une température et/ou une fréquence.

16. Procédé d'étalonnage selon la revendication 11, **caractérisé en ce que** ladite étape d'ajustement dudit signal de référence comprend l'étape consistant à maintenir les caractéristiques de signal nominales dudit signal de référence sur la base de mesures directes des caractéristiques de signal du signal de référence.

17. Procédé d'étalonnage selon l'une quelconque des revendications 11 à 16, **caractérisé en ce que** les caractéristiques de signal incluent un niveau de signal et/ou une phase de signal et/ou un retard de signal.

18. Système amplificateur de puissance comprenant un système adaptatif de conditionnement de signaux selon l'une quelconque des revendications 1 à 10.

19. Système amplificateur de puissance selon la revendication 18, dans lequel ledit système de conditionnement de signaux comprend un module de prédistorsion dans le chemin de signal menant à un amplificateur de puissance du système amplificateur de puissance, et ledit moyen d'étalonnage est configuré de manière à étalonner ledit chemin de retour relativement à un gain pour permettre une adaptation des paramètres de module de prédistorsion relativement à un niveau de signal, de sorte que la précision de la puissance de sortie du système amplificateur de puissance est maintenue.

20. Système émetteur comprenant un système adaptatif de conditionnement de signaux selon l'une quelconque des revendications 1 à 10.

21. Système émetteur selon la revendication 20, dans lequel ledit système émetteur comprend:

- de multiples branches de transmission de signal (802 - 826; 902 - 926; 1002 - 1026; 1110, 1120), dont chacune comprend un conditionneur de signaux (810; 910; 1010; 1110); et
- au moins un chemin de retour sensible au signal de génération en sortie d'au moins une branche de transmission pour permettre une adaptation de paramètres utilisés par le conditionneur de signaux correspondant;

dans lequel ledit signal de référence est inséré dans ledit au moins un chemin de retour en vue de l'étalonnage de celui-ci.

22. Système émetteur selon la revendication 21, **caractérisé en ce que** lesdites branches de transmission partagent de manière alternée un chemin de retour commun, avec une connexion de retour allant de la sortie de chaque branche de transmission audit chemin de retour commun, et **en ce que** ledit signal de référence est inséré dans ledit chemin de retour commun en vue de l'étalonnage de celui-ci.

23. Système émetteur selon la revendication 21, **caractérisé en ce que** chaque branche de transmission est associée à son propre chemin de retour, et **en ce que** tous les chemins de retour sont étalonnés en utilisant le même signal de référence.

24. Système émetteur selon la revendication 21, **caractérisé en ce que** ledit système émetteur est un système d'antenne adaptative, et **en ce que** ledit moyen d'étalonnage étalonne ledit au moins un chemin de retour relativement à un gain et/ou un déphasage.

**25.** Système émetteur selon la revendication 21, **caractérisé en ce que** ledit système émetteur est un système de diversité de transmission, et **en ce que** ledit moyen d'étalonnage étalonne ledit au moins un chemin de retour relativement à un retard pour permettre une adaptation des paramètres utilisés par les conditionneurs de signaux dans les branches de transmission, de sorte que la précision de l'adaptation de retard entre les branches de transmission est maintenue.

**26.** Système émetteur selon la revendication 21, **caractérisé en ce que** chacune desdites branches de transmission comprend un amplificateur de puissance au niveau du chemin de signal d'entrée à une antenne (828; 928; 1028).

**27.** Système émetteur selon la revendication 21, **caractérisé en ce que** chaque branche de transmission est associée à sa propre antenne (828; 928; 1028).

**28.** Système émetteur selon la revendication 21, **caractérisé en ce que** certaines desdites branches de transmission sont associées en vue de produire un signal de sortie destiné à être transmis par une antenne (1128).

Fig. 1
(Prior art)

Fig. 2

EP 1 425 849 B1

Fig. 3

EP 1 425 849 B1

CALIBRATION

SELECTIVELY INSERTING A REFERENCE
SIGNAL INTO THE FEEDBACK PATH OF
AN ADAPTIVE SIGNAL CONDITIONING SYSTEM ~401

MEASURING CHANGES IN REFERENCE
SIGNAL CHARACTERISTICS OVER THE
FEEDBACK PATH ~402

DETERMINE CALIBRATION SETTING
BASED ON THE MEASUREMENTS ~403

CALIBRATED OPERATION

COMPENSATING FOR CHANGES IN TRANSFER
CHARACTERISTICS OF THE FEEDBACK PATH
BASED ON THE CALIBRATION SETTING ~404

ADAPTING THE SIGNAL CONDITIONING BASED
ON A CALIBRATED FEEDBACK SIGNAL ~405

Fig. 4

EP 1 425 849 B1

500

520

510

TO THE
FEEDBACK
PATH

COMPENSATED
REFERENCE
SIGNAL

COMPENSATOR

REFERENCE
SIGNAL

534

532

530

SIGNAL ADJUSTMENT CONTROLLER

REFERENCE SIGNAL GENERATOR BLOCK

Fig. 5

Fig. 6

Fig. 7

Fig. 8

EP 1 425 849 B1

Fig. 9

Fig. 10

EP 1 425 849 B1

## Fig. 11

**1110-1** BRANCH SIGNAL CONDITIONING

**1120-1** SIGNAL CONVERSION SYSTEM

**1110-2** BRANCH SIGNAL CONDITIONING

**1120-2** SIGNAL CONVERSION SYSTEM

INPUT → OVERALL SIGNAL CONDITIONING

**1110-M**

**1128**

**1160-1** PARAMETER ADAPTATION

**1150-1** **1145-1**

**1133-1** FEEDBACK COMPONENTS

**1135-1**

COEFFICIENT CALIBRATOR **1140-1**

**1160-2** PARAMETER ADAPTATION

**1150-2** **1145-2**

**1133-2** FEEDBACK COMPONENTS

**1135-2**

COEFFICIENT CALIBRATOR **1140-2**

**1160-M** **1150-M** **1130-M**

PARAMETER ADAPTATION ← CALIBRATION ← FEEDBACK

**1135-M**

REF

EP 1 425 849 B1

31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4291277 A
- US 5483681 A
- US 5937011 A
- US 5909642 A
- US 6072364 A
- US 6141390 A
- WO 9749174 A
- EP 1047185 A
- US 4462001 A
- US 4700151 A
- US 5049832 A

**Non-patent literature cited in the description**

- **R. C. Davis ; J. Grabowski.** An Experimental MQAM Modem Using Amplifier Linearization and Baseband Equalization Techniques. *Proc. Natl. Commun. Conf.,* 1982, E3.2.1-E3.2.6
- **X. Vuong ; H. Moody.** Realization of Predistortion Compensators of Memoryless Nonlinear Devices. *Spar Aerospace,* 1980
- **Saleh, Salz.** Adaptive Linearization of Power Amplifiers. *Bell Journal, Bell Labs,* April 1983
- **S. C. Cripps.** RF Power Amplifiers for Wireless Communications. *Artech House,* 1999, 219-250